# EUROPÄISCHE PATENTSCHRIFT

(11) **EP 1 620 858 B1**
(45) Veröffentlichungstag und Bekanntmachung des Hinweises auf die Patenterteilung: **04.01.2012**
(21) Anmeldenummer: 04722859.8
(22) Anmeldetag: 24.03.2004
(51) Int. Cl.: G11C 11/15, H03K 17/22, H03K 17/80, H03K 19/173

(54) **BAUELEMENT MIT EINER IN IHRER FUNKTIONALITÄT KONFIGURIERBAREN LOGIKSCHALTUNGSANORDNUNG**
COMPONENT WITH A LOGIC CIRCUIT ARRANGEMENT WITH CONFIGURABLE FUNCTIONALITY
COMPOSANT POURVU D'UN ENSEMBLE CIRCUIT LOGIQUE A FONCTIONNALITE CONFIGURABLE

(30) Priorität: 08.05.2003 DE 10320701
(43) Veröffentlichungstag der Anmeldung: 01.02.2006
(73) Patentinhaber: SIEMENS AKTIENGESELLSCHAFT, 80333 München (DE)
(72) Erfinder: BANGERT, Joachim, 91052 Erlangen (DE); SIEMERS, Christian, 38446 Wolfsburg (DE)
(86) Internationale Anmeldenummer: PCT/EP2004/003134
(87) Internationale Veröffentlichungsnummer: WO 2004/100170

(56) Entgegenhaltungen:
- WO-A-03/026131
- DE-C- 10 053 206
- DE-C- 10 144 384
- DE-C- 10 144 395
- US-B1- 6 542 000
- LOWREY, TYLER: "OUM - Ovonic Unified Memory" [Online] Dezember 1999 (1999-12), OVONYX , XP002296442 Gefunden im Internet: URL:http://www.ovonyx.com/technology.pdf> [gefunden am 2004-09-10] Seiten 5,20,28 Seiten 34,58-63 Seite 78

## Beschreibung

Die Erfindung betrifft ein Bauelement mit einer in ihrer Funktionalität konfigurierbaren Logikschaltungsanordnung, umfassend mehrere Datenleitungen.

Konfigurierbare Bauelemente sind seit langem bekannt, sie werden, nachdem sie vorzugsweise Logikfunktionen ausführen, allgemein als Programmable Logic Device (PLD) bezeichnet. Solche PLD-Bauelemente werden vornehmlich für weniger komplexe Aufgaben eingesetzt. Derartige Logikbausteine sind z. B. aus US 4,870,302 oder der Veröffentlichung "Ranmuthu, I.W. et al.; Magneto-resistive elements - An Alternative to Floating Gate Technology; In: Proceedings of the Midwest Symposiums on Circuits and Systems, 1992, pg(s). 134 - 136 vol. 1" bekannt. Das Anwendungsprogramm wird bei solchen Logikbausteinen beim Booten definiert: Aus einem Programmspeicher wird ein Programm ausgelesen, konfigurierbare Bereiche werden konfiguriert. Die konfigurierbaren Bereiche haben folgende Eigenschaften: Entweder definieren sie Verknüpfungen zwischen vorgegebenen Punkten (Routing-Bereiche) oder definieren die Verarbeitung logischer Eingangssignale zu logischen Ausgangssignalen (Logikzellen-Bereiche).

Die Programmierinformation wird also in der Fläche verteilt. Die Konfigurierbarkeit der PLD's beschränkt sich auf wenige konfigurierbare Parameter, die beim Booten fest eingestellt werden. Es werden dabei zwei Speicher benötigt: Ein externer Boot-Speicher-Chip (diskreter Chip, z. B. ein EEPROM 113 in US 4,870,302) und interne, flächig verteilte Speicherzellen (z. B. nach Fig. 3a und 10a in US 4,870,302 oder Fig. 5 in der Veröffentlichung von Ranmuthu at al.). Die lokalen Speicherzellen enthalten nach dem Booten die Informationen für die Verknüpfungen und für die Logikfunktionen der Zellen. Wesentliche Parameter zur Bewertung der Leistungsfähigkeit dieser Speicher sind der Flächenbedarf und der statische (Leck-)Energieverbrauch als statische "Kosten" sowie die Schaltgeschwindigkeit und -kapazität als dynamische "Kosten". Betrachtet werden nachfolgend nur nichtflüchtige, re-konfigurierbare Architekturen, nämlich SRAM in Kombination mit Boot-ROM oder EEPROM. Das SRAM ist eine relativ große Zelle, besitzt eine schnelle Arbeitsgeschwindigkeit und ist ein flüchtiger Speicher, das Boot-ROM ist dagegen langsam und nicht-flüchtig. Das EEPROM ist eine mittelgroße Zelle mit langsamer Arbeitsgeschwindigkeit, hohem Konfigurierleistungsbedarf und geringem "Lese"-Leistungsverbrauch.

Die Flächen- und die Verlustleistungseffizienz der verteilten Speicherzellen ist ca. bis zu zwei Größenordnungen schlechter als die von diskreten Speicherchips gleicher Leistungsfähigkeit. Benötigt das Anwendungsprogramm aber weniger Leistungsfähigkeit als die Chips bereitstellen, so verbrauchen die nicht genutzten Bereiche unvermeidlich ebenfalls Verlustleistung. Typische Ausnutzungsgrade der vorhandenen Logikblocks von PLD's liegen bei ca. 30 % bis 70 %. Zu einem bestimmten Zeitpunkt sind davon auch nur Bruchteile aktiv an der Verarbeitung von Logikinformationen beteiligt.

Ein Bauelement, insbesondere in Form einer Logikschaltungsanordnung, verfügt über eine Vielzahl von Datenleitungen, die die einzelnen Funktionselemente der Schaltungsanordnung miteinander verknüpfen, die also Logikzellen miteinander verbinden, den Routing-Bereich definieren oder sonstige Signalverbindungen bestimmen. Die Datenleitungen definieren also den Daten- oder Signaltransferweg, also die Verknüpfung zwischen vorgegebenen Punkten und die Signalverarbeitung. Dem konfigurierten Verlauf der Datenleitungen kommt also im Rahmen der Konfiguration eine wichtige Funktion zu.

Das Dokument DE 101 44 384 offenbart ein Bauelement mit einer in ihrer Funktionalität konfigurierbaren logikschaltungsanordnung, umfassend mehrere Datenleitungen.

Der Erfindung liegt das Problem zugrunde, eine Möglichkeit anzugeben, auf einfache Weise auf den Verlauf oder Zustand einer Datenleitung im Rahmen der Konfiguration Einfluss nehmen zu können.

Zur Lösung dieses Problems ist ein Bauelement der eingangs genannten Art vorgesehen, wobei zumindest einem Teil der Datenleitungen wenigstens ein zwischen zwei Zuständen mit unterschiedlichen diskreten Widerständen schaltbares Element zugeordnet ist, über welches Element je nach geschaltetem Zustand die Datenleitung freigegeben oder gesperrt wird, wobei der Schaltzustand des Elements nicht-flüchtig speicherbar und schnell umschaltbar ist.

Beim erfindungsgemäßen Bauelement kommt ein in seinem Widerstand schaltbares Element zum Einsatz, wobei die Datenleitung abhängig vom jeweils schaltungsbedingt eingestellten Widerstand des Elements entweder freigegeben wird, Daten also transferiert werden können, oder aber gesperrt wird, der Datentransfer also unterbrochen wird. Durch Ändern der Widerstands-Charakteristik des zugeordneten Elements kann also sehr schnell die Datenleitung freigegeben oder geöffnet werden.

Ist das Element in einer Reihenschaltung angeordnet, so wird die eine Quelle und ein dieser nachgeschaltetes Teil, z.B. ein Gatter verbindende Datenleitung durch die Widerstandsänderung des Elements freigegeben (niedriger Widerstand) oder gesperrt (hoher Widerstand). In einer Parallelschaltung, wo das Element parallel zur Datenleitung ist, wird das Signal entweder kurzgeschlossen (niedriger Widerstand) oder das Element tritt nicht in Erscheinung (hoher Widerstand), das Signal wird ungehindert über die Datenleitung geführt. Schließlich besteht die Möglichkeit, eine Serienschaltung eines erfindungsgemäßen Bauelements mit einem Ausgangs-Transistor folgendermaßen zu beschalten: niederohmiges Verhalten bedeutet Datenleitung ist konstant (z.B. Pluspol), Information ist gesperrt. Ist das Bauelement hochohmig geschaltet, verhält es sich als Pullup-Widerstand, das Quellensignal läuft über die Datenleitung.

Besonders wichtig ist, dass die Änderung des Widerstands in geeigneter Weise ohne weitere Energiezufuhr speicherbar wird und somit stets zur Verfügung steht. Vorteilhaft wäre es, wenn die Änderung zu jeder zeit durchgeführt werden kann, ohne Beschränkung der Anzahl der Zyklen und auch mit hoher Geschwindigkeit. Die Umschaltgeschwindigkeit sollten ≤ 3ns betragen.

Als Element kann erfindungsgemäß ein einen magneto-resistiven Effekt zeigendes Element eingesetzt werden, vorzugsweise eine TMR-Zelle (TMR = Tunnel-Magneto-Resitive). Derartige magnetoresistive Elemente zeichnen sich dadurch aus, dass ihr Widerstandsverhalten durch die Stellung der Magnetisierung einer weichmagnetischen Informationsschicht bezüglich einer hartmagnetischen Referenzschicht bestimmt wird. Je nach dem, ob die Magnetisierungen parallel oder antiparallel zueinander stehen, ist ein niedriger oder hoher Widerstand über das Element realisiert. Die Änderung der Magnetisierungsrichtung der weichmagnetischen Schicht kann auf einfache und schnelle Weise erfolgen, wozu ein über einen Konfigurierleiter geführter Konfigurierstrompuls, der ein auf die Magnetisierung der weichmagnetischen Schicht wirkendes Magnetfeld erzeugt, dient.

Alternativ - oder zusätzlich zur Verwendung von magnetoresistiven Elementen - kann das Element auch eine Widerstandsänderung durch eine beim Schalten erzeugte Phasenänderung, insbesondere von einem amorphen Zustand in einen kristallinen Zustand zeigen. Das Element ist also als Phasenwechselzelle, die auch als OUM-Zelle bezeichnet werden kann (OUM = Ovonic Unified Memory) ausgebildet.

Eine auf diesem Effekt aufbauende Phasenwechselzelle ist ein Speicher, dessen Speichermechanismus auf einer reversiblen strukturellen Phasenänderung von einer amorphen Phase in eine kristalline Phase beruht. Als Phasenänderungsmaterial kann ein Chalkogenid-Legierungsmaterial in Form eines Dünnfilms verwendet werden. Bei einer Phasenänderung ändert sich der Widerstand zwischen zwei diskreten Werten, d.h. auch hier kommt es beim Schalten zu einer Änderung zwischen einem hohen und einem niedrigen Widerstand. Es handelt sich also um einen schnell programmierbaren Widerstandsspeicher. Als Phasenwechselsysteme können binäre Systeme (z.B. GaSb, InSb, InSe, Sb₂Te₃, GeTe), tertiäre Systeme (z.B. Ge₂Sb₂Te₅, InSbTe, GaSe-Te, SnSb₂Te₄, InSbGe) oder quaternäre Systeme (z.B. AgInSbTe, (GeSn) SbTe, GeSb(SeTe), Te₈₁Ge₁₅Sb₂S₂) verwendet werden, wobei bevorzugt das GeSbTe-Legierungssystem verwendet wird. Während die amorphe Phase eine enge Atomanordnung, eine niedrige Dichte an freien Elektronen, eine hohe Aktivierungsenergie und einen hohen Widerstand zeigt, sind die Verhältnisse der kristallinen Phase gerade umgekehrt, es stellt sich eine längere Atomanordnung, eine höhere Dichte an freien Elektronen, eine niedrigere Aktivierungsenergie sowie ein niedriger Widerstand ein. Der Schaltvorgang kann mit niedrigen Schaltspannungen erfolgen, wobei zum Schalten ein Strompuls mit einer Steuerspannung oberhalb der Thresholdspannung der Zelle dient. Die Zellinformation wird auch hier über den eingestellten Widerstand ausgelesen. Eine Phasenwechselzelle ist z.B. in der veröffentlichten Website http://www.ovonyx.com/tech_html.html beschrieben.

Allen verwendbaren Elementen gemein ist, dass ihr Widerstand zwischen zwei diskreten Werten geschaltet werden kann. Durch die Widerstandsänderung ändert sich zwangsläufig ein über das jeweilige Element geführter Strom. Nach einer ersten Erfindungsausgestaltung kann nun vorgesehen sein, dass über das Element ein (in die Datenleitung geschalteter) Pass-Transistor gesperrt oder freigegeben wird. Dieser Pass-Transistor wird über das ihm jeweils zugeordnete Element geschaltet. Die Öffnung oder Freigabe der Datenleitung wird also indirekt oder mittelbar über das Element gesteuert, das den direkt in die Datenleitung geschalteten Pass-Transistor schaltet. Der über ein Element oder beispielsweise zwei gekoppelte Elemente geführte Strom bzw. Summenstrom wird am Gate-Eingang des vorzugsweise als MOS-Transistors ausgeführten Pass-Transistors angelegt. Je nach dem, wie groß diese Steuerspannung ist, wird der Pass-Transistor durchgeschaltet oder gesperrt. Wird er durchgeschaltet, so ist die Datenleitung, in die der Transistor geschaltet ist, freigegeben. Wird er gesperrt, wird gleichzeitig auch die Datenleitung gesperrt, Informationen können über sie nicht übertragen werden. Im Falle einer Parallelschaltung des Elements zur Datenleitung schließt es diese im niederohmigen Zustand kurz, im hochohmigen Zustand ist es transparent.

Dabei kann zum Betätigen des Pass-Transistors lediglich ein Element vorgesehen sein, sofern das Widerstandsverhältnis, also das Verhältnis zwischen dem niedrigen schaltbaren Widerstand und dem hohen schaltbaren Widerstand hinreichend hoch ist, so dass ein hinreichend hohes Spannungsverhältnis an den Gate-Eingang zum Steuern des Transistors gelegt werden kann. Alternativ zur Verwendung lediglich eines ein hohes Widerstandsverhältnis aufweisenden Elements ist es auch denkbar, zwei miteinander gekoppelte und parallel betriebene Elemente vorzusehen, über die eine Summenspannung an den Gate-Eingang gelegt werden kann. Werden zwei TMR-Zellen zur Ansteuerung eines Pass-Transistors verwendet, so werden diese zweckmäßigerweise invertiert angesteuert.

In Weiterbildung des Erfindungsgedankens kann vorgesehen sein, dass die beiden Elemente, insbesondere die beiden TMR-Zellen ein Widerstandsverhältnis zwischen den beiden zustandsbezogenen Widerständen ungleich 1:1, insbesondere von 1:2 oder höher aufweisen. Je höher das Widerstandsverhältnis ist, desto weiter werden die von den jeweiligen Widerständen abhängigen Steuerspannungen voneinander getrennt.

Neben der Möglichkeit, über ein oder mehrere Elemente einen Pass-Transistor zur Freigabe oder zum Sperren der Datenleitung zu steuern und die Datenleitung indirekt über das Element zu schließen oder zu öffnen, besteht nach einer alternativen Erfindungsausgestaltung auch die Möglichkeit, dass ein Element unmittelbar in die Datenleitung geschaltet ist und diese direkt öffnet oder sperrt. Nach dieser Erfindungsausgestaltung wird also ein solches Element direkt als Pass-Transistor verwendet. Voraussetzung dafür ist, dass sich ein hinreichend hohes Widerstandsverhältnis zwischen den beiden zustandsbezogenen Widerständen von wenigstens 1:10 oder grö-βer am Element realisieren lässt. Bei Einstellung des niedrigen Widerstands wäre bei dieser Ausführungsform die Datenleitung freigegeben, bei Einstellung des hohen Widerstands wäre sie gesperrt.

Für die Ausführung als Parallelschaltung gelten obige Ausführungen sinngemäß.

Insgesamt bietet das erfindungsgemäße Bauelement im Vergleich zu bisher verwendeten Technologien bzw. Architekturen eine Reihe von Vorteilen. Die gängigen Technologien bedienen sich einer Konfigurationsspeicherung mit einem SRAM-Speicher oder einem EEPROM-Speicher.

SRAM-Zellen können grundsätzlich nur einen Pass-Transistor ansteuern. Die Ursache hierzu liegt im Operationsprinzip dieser Zelle, das auf dem Flip-Flop-Prinzip basiert. Hier werden Transistoren gegenseitig so gekoppelt, dass die Schaltung zwei stabile Zustände kennt und diese Zustände nach außen hin als Spannung sichtbar sind. Der Einsatz eines erfindungsgemä-βen Elements erniedrigt dabei die Anzahl der Transistoren pro Pass-Element, bei Verwendung zweier Elemente zum Schalten eines Pass-Transistors sind lediglich drei Flächeneinheiten nötig (die beiden Elemente sowie der Pass-Transistor selbst) bzw. wird nur eine Flächeneinheit benötigt, wenn ein Element selbst als Pass-Transistor verwendet wird. Die Flächengröße einer TMR-Zelle ist ≤ der Flächengröße eines Transistors. Als weiterer Vorteil ist der Erhalt der Konfiguration bei Ausfall der Versorgungsspannung zu sehen, der ein zusätzliches Boot-Memory unnötig macht. D.h., dass zur dauerhaften Speicherung im vergleich zum SRAM keine Energiezufuhr nötig ist. Gleichwohl lassen sich sehr schnelle Umschaltzeiten (≤ 3ns) realisieren, da der Widerstand sehr schnell schaltbar ist.

Auch ein EEPROM (inklusiv Flash) besteht aus mehreren Transistoren, die aufwendig und langsam reprogrammierbar sind und schlechte Laufzeiten aufweisen, verglichen mit einem einfachen Pass-Transistor. Zudem sind die EEPROM-Transistoren größer als normale Transistoren, da eine zusätzliche Leiterbahn für die Tunnelstrecke erforderlich ist. Gegenüber der EEPROM-Technologie bietet die Verwendung der Elemente, insbesondere der TMR-Zelle den Vorteil der schnellen und unkomplizierten Umprogrammierung. Dieser Vorteil ist zentral, da zukünftig dynamisch rekonfigurierbare Bauelemente eingesetzt werden. Dies ist mit EEPROM-Zellen nicht denkbar oder möglich, da EEPROM-Zellen nur eine langsame Schaltgeschwindigkeit des Floating-Gates im µs-Bereich zeigen, wohl aber mit den in ihrem Widerstand veränderbaren Zellen, insbesondere in Form der TMR-Zellen.

Weitere Vorteile, Merkmale und Einzelheiten der Erfindung ergeben sich aus den im folgenden beschriebenen Ausführungsbeispielen sowie anhand der Zeichnungen. Dabei zeigen:
- Fig. 1: eine Prinzipskizze eines Schichtsystems einer TMR-Zelle,
- Fig. 2: eine Prinzipskizze der Reihen-Verschaltung zweier Elemente zur Steuerung eines Pass-Transistors,
- Fig. 3: eine ausführlichere Darstellung der Anordnung aus Fig. 2,
- Fig. 4: einen Schnitt durch die Anordnung aus Fig. 3,
- Fig. 5: eine Prinzipskizze eines unmittelbar in der Datenleitung angeordneten, als Pass-Transistor dienenden Elements, und
- Fig. 6: eine Prinzipskizze einer Parallelschaltung des Pass-Transistors zur Datenleitung.

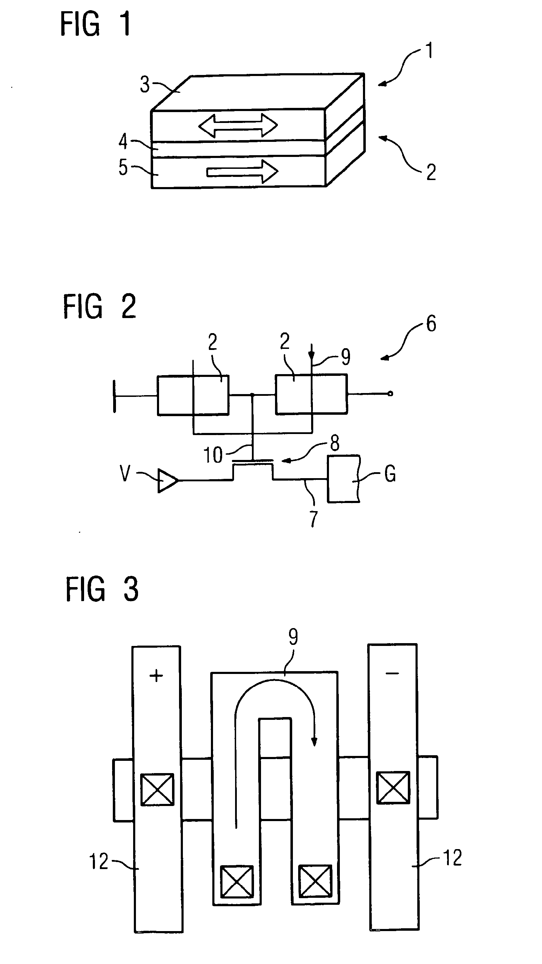

Fig. 1 zeigt in Form einer Prinzipskizze ein Element 1 in Form einer TMR-Zelle 2, bestehend aus einer weichmagnetischen Informationsschicht 3, einer elektronischen Barrierenschicht 4 und einer hartmagnetischen Referenzschicht 5.

Die weichmagnetische Schicht oder ein weichmagnetisch wirkendes Schichtpaket, das diese Informationsschicht 3 bildet, kann durch Ströme oder Strompulse auf Leiterbahnen ummagnetisiert werden, welche Ströme oder Strompulse ein Magnetfeld oder einen Magnetpuls erzeugen, der auf die Schichtmagnetisierung wirkt. Kennzeichen ist die Koerzitivfeldstärke (symmetrisch zu H=0) und eine Spinpolarisation und eine Remanenz. Die Basismaterialien sind bekannte magnetische Materialien geringer oder mittlerer Koerzitivfeldstärke. Der Doppelpfeil deutet die Anisotropieachse an, in die sich die Magnetisierung einstellen lässt. Damit sind zwei diskrete Magnetisierungszustände einstellbar.

Die Barrierenschicht 4 bildet eine elektronische Barriere, sie entsteht durch eine abrupte Änderung in der Bandstruktur. Dies kann durch Materialgrenzflächen, aber beispielsweise auch durch Dotierungen erreicht werden. Die elektronische Barriere ermöglicht direktes Tunneln von Ladungsträgern zwischen den angrenzenden Elektroden. Die Eigenschaften der elektronischen Barriere bestimmen den "Grundwiderstand" der Elemente, und auch die Spannungsabhängigkeit der Kennlinie. Weiteres Kriterium ist die Erhaltung der Spinpolarisation während des Tunnelns bzw. ein totaler Spinflip (z. B. aus Spin-up wird Spin-down). Für den TMR-Effekt werden folgende Isolatormaterialien als Barrierenmaterialien häufig eingesetzt: AlOₓ, AlN, TaOₓ, BN, MgO; halbleitende Materialien: ZnS, GaOₓ; weitere Materialien: NiO, NbO, HfO₂, TiO₂ SiO₂, Fe₂O₃, Fe₃O₄. Die Materialdicke beträgt wenige Atomlagen bis zu einigen Nanometern. Es werden kristalline und amorphe Barrieren verwendet.

Die Referenzschicht 5 ist magnetisch hart und kann (idealerweise) von Signalen im Chip und externe Felder nicht verändert werden. Sie besteht mindestens aus der Referenzschicht oder (normalerweise) aus einer komplexen Schichtfolge (=Schichtsystem), die die Referenzschicht enthält. Wesentlich für die TMR-Zelle ist, dass wenigstens eine magnetische Schicht aktiv mit den Elektronen wechselwirkt. Dies ist jeweils diejenige Schicht, die an die nicht-magnetische Zwischenschicht angrenzt. Da sie Teil der magnetisch harten Schicht ist, ist deren Magnetisierung vorgegeben und sie enthält die Referenzmagnetisierung für den TMR-Effekt (bzw. dem GMR-Effekt). Typische magnetische Materialien sind Schichten mit hoher Spinpolarisation (z. B. CoFe, Py, Fe) und gleichzeitig hoher Austauschwechselwirkung zur benachbarten Schicht in der harten Schicht. In manchen Schichtaufbauten kann die harte Schicht auch zwei Referenzschichten aufweisen, zum Beispiel bei einer harten Schicht in der Mitte eines symmetrischen GMR-Aufbaus.

Fig. 2 zeigt einen Ausschnitt aus einer erfindungsgemäßen Schaltungsanordnung 6 eines erfindungsgemäßen Bauelements, bei dem es sich um ein beliebiges Bauelement, vornehmlich um eine Logikschaltungsanordnung handeln kann. Gezeigt ist eine Datenleitung 7, in die im gezeigten Ausführungsbeispiel ein Pass-Transistor 8 geschaltet ist, über den die Datenleitung 7, die z. B. zwei beliebige Logikelemente, z. B. einen Verstärker V und ein Gatter G oder einzelne Logikzellen, miteinander verknüpft, geöffnet oder gesperrt werden kann. Zum Schalten des Pass-Transistors 8 sind zwei TMR-Zellen 2 vorgesehen, deren Widerstand über einen über eine Konfigurierstromleiterbahn 9 geführten Konfigurierstrom, der ein entsprechendes Magnetfeld erzeugt, eingestellt werden kann. Die widerstandsbedingt über die beiden miteinander gekoppelten TMR-Zellen 2 (die auch als Twin-Zelle benannt werden können) abfallende Steuerspannung wird über die Verbindung 10 auf den Gate-Eingang des Pass-Transistors 8 gelegt. Abhängig von der Größe dieser Steuerspannung wird der Pass-Transistor 8 entweder gesperrt oder durchgeschaltet.

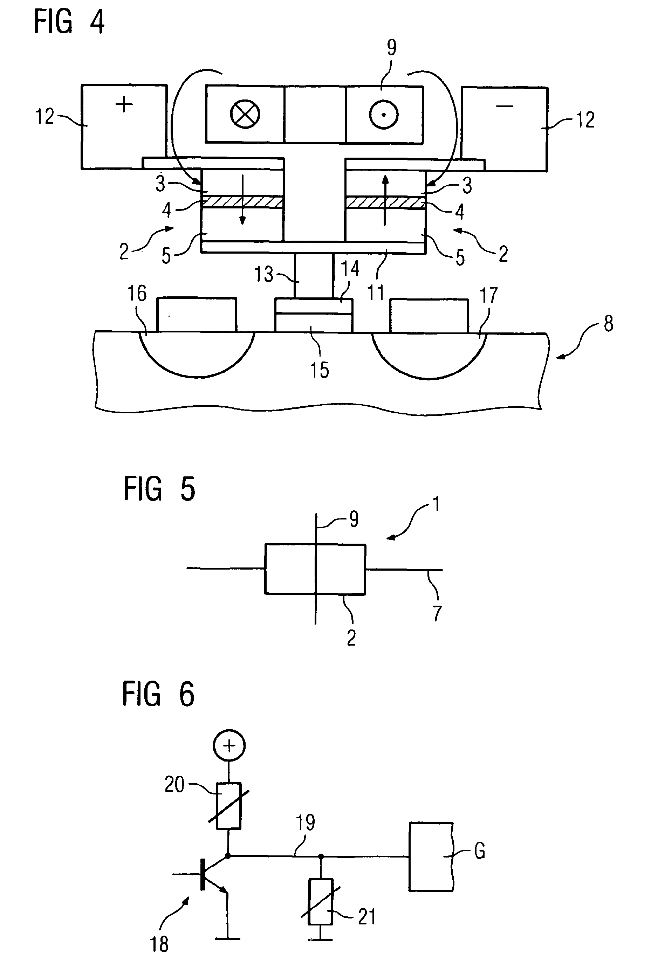

Die Figuren 3 und 4 zeigen die Schaltungsanordnung 6 aus Fig. 2 im Detail. Gezeigt sind die beiden TMR-Zellen 2, die beispielsweise an ihrem referenzschichtseitigen Ausgang über eine Kopplungsleitung 11 miteinander gekoppelt sind. An der gegenüberliegenden Seite ist jede TMR-Zelle 2 mit einem Pol einer Stromversorgung 12 gekoppelt, so dass insgesamt ein Strom über die Twin-Zellenanordnung geführt werden kann. Gezeigt ist ferner der Konfigurierstromleiter 9, der sich umkehrend oberhalb der TMR-Zellen 2 geführt ist. Über ihn kann ein Konfigurierstrom geführt werden, wie durch den gebogenen Pfeil in Fig. 3 dargestellt ist. Nachdem die Stromrichtung aufgrund der Leiterführung über den beiden TMR-Zellen 2 entgegengesetzt ist, werden antiparallel gerichtete Magnetfelder erzeugt, wie durch die beiden Pfeile in Fig. 4 um den Konfigurierstromleiter 9 herum dargestellt ist, d. h. die beiden Zellen werden antiparallel zueinander betrieben. Je nach dem, wie nun die Stromrichtung über den Konfigurierstromleiter 9 ist, kann die Richtung der jeweils erzeugten Magnetfelder eingestellt werden und über diese die Magnetisierung der benachbarten weichmagnetischen Schicht 3 beider TMR-Zellen 2. Auf diese Weise kann der jeweilige Widerstand einer TMR-Zelle sehr einfach zwischen einem zustandsabhängigen niedrigen und hohen Wert geschaltet werden. Bei einem Widerstandsverhältnis von 1:2 ergibt sich daraus immer der dreifache minimale Widerstand eines Elements als Belastungswiderstand für die Versorgungsspannung sowie ein Steuerspannungswert von 2/3 der Versorgungsspannung bzw. 1/3 der Versorgungsspannung. Bei entsprechend konzipierter Thresholdspannung des Pass-Transistors, der z. B. als MOS-Transistor ausgeführt ist, ist dieses Spannungsverhältnis ausreichend, um die Zustände "Transistor sperrt" und "Transistor leitet" anzusteuern. Der Einfluss auf die Datenleitung 7 ergibt sich durch die verstärkenden Eigenschaften des Transistors als gesteuerter Widerstand. Lässt sich das Widerstandsverhältnis erhöhen, werden die Steuerspannungen entsprechend weiter voneinander getrennt. Eine Sättigung des Transistors sollte jedoch vermieden werden.

Die an der Twin-Zellenanordnung erzeugte Steuerspannung wird über eine entsprechende Verbindung 13 auf den Eingang 14 des Gates 15 des Pass-Transistors 8 gegeben. Die Funktion eines solchen Transistors ist bekannt, je nach Größe der am Gate 15 anliegenden Steuerspannung wird der Transistor leitend, er wird also durchgeschaltet, oder er wird gesperrt. Es kann also auf einfache Weise durch Änderung der Widerstandsverhältnisse an der Twin-Zellenanordnung der Transistorzustand geschaltet werden.

Der Abstand zwischen den beiden TMR-Zellen 2 liegt in der gleichen Größenordnung wie die Gate-Länge (einige 100 nm). Source- und Drain-Ströme im Source-Bereich 16 bzw. Drain-Bereich 17 des Pass-Transistors 8 sind im Vergleich zu den Konfigurierströmen vernachlässigbar, daher kann der Abstand zwischen den beiden TMR-Zellen 2 und dem Gate 15 durch die notwendigen Isolationsabstände bestimmt werden. Der Aufbau ist folglich sehr kompakt. Sinnvoll erscheint es, große TMR-Widerstände zur Minimierung des Querstroms zwischen den Polen der Stromversorgung 12 zu realisieren, was über eine dicke Barrierenschicht und eine kleine Fläche möglich ist.

Fig. 5 zeigt in Form einer Prinzipskizze eine alternative Ausführung, die gleichermaßen dienlich ist, um die Datenleitung 7 freizugeben oder zu sperren. Hier ist ein Element 1, im Ausführungsbeispiel eine TMR-Zelle 2 direkt in die Datenleitung 7 geschaltet. Voraussetzung ist, dass die TMR-Zelle 2 ein hohes Widerstandsverhältnis von vorzugsweise etwa 1:10 und mehr zeigt. Sie kann dann direkt als Pass-Transistor eingesetzt werden, wodurch die Anzahl erforderlicher Transistoren zum Schalten der Datenleitung 7 weiter reduziert wird. Die Datenleitung wird geöffnet, wenn an der TMR-Zelle, der gleichermaßen ein Konfigurationsstromleiter 9 zugeordnet ist, um den Widerstand der weichmagnetischen Schicht schalten zu können, ein niedriger Widerstand eingestellt ist. Sie wird gesperrt, wenn der hohe Widerstand durch entsprechendes Schalten der Magnetisierung der weichmagnetischen Schicht eingestellt ist.

Die Verdrahtung der konfigurierbaren Schaltung durchläuft die TMR-Zelle 2. Die Konfigurationsleiterbahn 9 ist Teil der Verdrahtung und kann über, unter oder kombiniert oberhalb und unterhalb der TMR-Zelle 2 verlaufen. Die Anschlüsse der TMR-Zelle können ins Silizium geführt werden oder in der Verdrahtungsschicht verbleiben.

Fig. 6 zeigt schließlich eine Schaltungsanordnung, bei der ein über zwei nicht näher gezeigte TMR-Zellen schaltbarer Transistor 18 dargestellt ist, wobei diese TMR-Zellen und der Transistor parallel zur zu "schaltenden" Datenleitung 19, die ein Gatter G über einen Pullup-Widerstand 20 an den Pluspol einer Spannungsversorgung, also eine Quelle legt, geschaltet sind. Weiterhin ist ein Pulldown-Widerstand 21 vorgesehen. Je nach dem, ob die TMR-Zellen hoch- oder niederohmig geschaltet sind, liegt das Gatter an der Quelle oder nicht. Sind die TMR-Zellen hochohmig, so verhalten sie sich transparent, der Transistor fungiert nicht als Senke und ist ebenfalls transparent. Sind die TMR-Zelle niederohmig, fungiert der Transistor als Senke, das Gatter liegt nicht am Pluspol an.

Wenngleich die obigen Ausführungsformen lediglich die Verwendung von TMR-Zellen beschreiben, ist es gleichermaßen denkbar, andere magneto-resistive Zellen, deren Widerstand entsprechend geschaltet werden kann, oder die beschriebenen Phasenwechselzellen einzusetzen.

## Patentansprüche

1. Bauelement mit einer in ihrer Funktionalität konfigurierbaren Logikschaltungsanordnung, umfassend mehrere Datenleitungen (7), wobei zumindest einem Teil der Datenleitungen (7) wenigstens ein zwischen zwei Zuständen mit unterschiedlichen diskreten Widerständen schaltbares Element (1) zugeordnet ist, über welches Element (1) je nach geschaltetem Zustand die Datenleitung (7) freigegeben oder gesperrt wird, wobei der Schaltzustand des Elements (1) nicht-flüchtig speicherbar und schnell umschaltbar ist, **dadurch gekennzeichnet, dass** über das Element (1) ein in die Datenleitung (7) geschalteter Pass-Transistor (8) gesperrt oder freigegeben wird, oder dass das Element (1) selbst als die Datenleitung (7) freigebender oder sperrender Pass-Transistor verwendet wird.

2. Bauelement nach Anspruch 1, **dadurch gekennzeichnet, dass** das Element (1) eine einen magnetoresistiven Effekt zeigendes Element ist.

3. Bauelement nach Anspruch 2, **dadurch gekennzeichnet, dass** das Element (1) eine TMR-Zelle (2) ist.

4. Bauelement nach Anspruch 1, **dadurch gekennzeichnet, dass** das Element (1) eine Widerstandsänderung durch eine beim Schalten erzeugte Phasenänderung, insbesondere von einem amorphen Zustand zu einem kristallinen Zustand zeigt.

5. Bauelement nach Anspruch 4, **dadurch gekennzeichnet, dass** das Element (1) eine OUM-Zelle ist.

6. Bauelement nach einem der vorangehenden Ansprüche, wobei über das Element (1) ein in die Datenleitung (7) geschalteter Pass-Transistor (8) gesperrt oder freigegeben wird, **dadurch gekennzeichnet, dass** zum Betätigen des Pass-Transistors (8) lediglich ein Element (1) oder zwei miteinander gekoppelte und parallel betriebene Elemente (1) vorgesehen ist/sind.

7. Bauelement nach Anspruch 6, **dadurch gekennzeichnet, dass** zwei TMR-Zellen (2) vorgesehen sind, die invertiert angesteuert werden.

8. Bauelement nach Anspruch 7, **dadurch gekennzeichnet, dass** die beiden Elemente (1), insbesondere die beiden TMR-Zellen (2) ein Widerstandsverhältnis zwischen den beiden zustandsbezogenen Widerständen ungleich 1:1, insbesondere von 1:2 oder mehr aufweisen.

9. Bauelement nach einem der Ansprüche 1 bis 5, wobei das Element (1) selbst als die Datenleitung (7) freigebender oder sperrender Pass-Transistor verwendet wird, **dadurch gekennzeichnet, dass** das Element (1) unmittelbar in die Datenleitung geschaltet ist und diese direkt öffnet oder sperrt, oder dass das Element (1) parallel zur Datenleitung geschaltet ist und diese kurzschließt oder sich transparent verhält.

10. Bauelement nach Anspruch 9, **dadurch gekennzeichnet, dass** das Element (1), insbesondere die TMR-Zelle (2) oder die OMU-Zelle, ein Widerstandsverhältnis zwischen den beiden zustandsbezogenen Widerständen von wenigstens 1:5, insbesondere von wenigstens 1:10 oder größer, aufweist/aufweisen.

11. Bauelement nach einem der vorangehenden Ansprüche, **dadurch gekennzeichnet, dass** die Schaltzeit zum Umschalten des Widerstands des Elements ≤ 5ns, insbesondere ≤ 3ns ist.

## Claims

1. Component with a logic circuit arrangement with configurable functionality, comprising a plurality of data lines (7), at least a portion of the data lines (7) being assigned at least one element (1) that can be switched between two states with different discrete resistances, by means of which element (1) the data line (7) is enabled or inhibited depending on the switched state, it being possible for the switching state of the element (1) to be stored in nonvolatile fashion and to be changed over rapidly, **characterized in that** a pass transistor (8) connected into the data line (7) is inhibited or enabled by means of the element (1), or **in that** the element (1) itself is used as the pass transistor that enables or inhibits the data line (7).

2. Component according to Claim 1, **characterized in that** the element (1) is an element exhibiting a magnetoresistive effect.

3. Component according to Claim 2, **characterized in that** the element (1) is a TMR cell (2).

4. Component according to Claim 1, **characterized in that** the element (1) exhibits a resistance change as a result of a phase change generated during switching, in particular from an amorphous state to a crystalline state.

5. Component according to Claim 4, **characterized in that** the element (1) is an OUM cell.

6. Component according to one of the preceding claims, a pass transistor (8) connected into the data line (7) being inhibited or enabled by means of the element (1), **characterized in that** only one element (1) or two elements (1) coupled to one another and operated in parallel is/are provided for actuating the pass transistor (8).

7. Component according to Claim 6, **characterized in that** two TMR cells (2) are provided, which are driven in inverted fashion.

8. Component according to Claim 7, **characterized in that** the two elements (1), in particular the two TMR cells (2), have a resistance ratio between the two state-related resistances not equal to 1:1, in particular of 1:2 or more.

9. Component according to one of Claims 1 to 5, the element (1) itself being used as a pass transistor that enables or inhibits the data line (7), **characterized in that** the element (1) is connected directly into the data line and directly opens or inhibits the latter, or **in that** the element is connected in parallel with the data line and short-circuits the latter or behaves in transparent fashion.

10. Component according to Claim 9, **characterized in that** the element (1), in particular the TMR cell (2) or the OUM cell, has/have a resistance ratio between the two state-related resistances of at least 1:5, in particular of at least 1:10 or greater.

11. Component according to one of the preceding claims, **characterized in that** the switching time for changing over the resistance of the element ist ≤ 5ns, in particular ≤ 3ns.

## Revendications

1. Composant pourvu d'un circuit logique à fonctionnalité configurable, comprenant plusieurs lignes de données, dans lequel au moins un élément (1), commutable entre deux états présentant des résistances discrètes différentes, est associé au moins à une partie desdites lignes de données, lequel élément (1) permet de débloquer ou bloquer la ligne de données (7) selon l'état commuté, l'état de commutation de l'élément (1) pouvant être stocké de manière non volatile et commuté rapidement, **caractérisé en ce que** l'élément (1) permet de bloquer ou débloquer un transistor série (8) monté dans la ligne de données (7), ou **en ce que** l'élément (1) lui-même est utilisé comme transistor série débloquant ou bloquant la ligne de données (7).

2. Composant selon la revendication 1, **caractérisé en ce que** l'élément (1) est un élément montrant un effet magnétorésistif.

3. Composant selon la revendication 2, **caractérisé en ce que** l'élément (1) est une cellule TMR (2).

4. Composant selon la revendication 1, **caractérisé en ce que** l'élément (1) montre une variation de résistance par suite d'un changement de phase généré lors de la commutation, en particulier d'un état amorphe à un état cristallin.

5. Composant selon la revendication 4, **caractérisé en ce que** l'élément (1) est une cellule OUM.

6. Composant selon l'une des revendications précédentes, dans lequel l'élément (1) permet de bloquer ou débloquer un transistor série (8) monté dans la ligne de données (7), **caractérisé en ce que** pour actionner le transistor série (8), seul un élément (1) ou deux éléments (1) couplés entre eux et fonctionnant en parallèle est/sont prévu(s).

7. Composant selon la revendication 6, **caractérisé en ce que** deux cellules TMR (2) sont prévues, qui sont commandées de manière inversée.

8. Composant selon la revendication 7, **caractérisé en ce que** les deux éléments (1), en particulier les deux cellules TMR (2), présentent un rapport de résistance entre les deux résistances par rapport à l'état différent de 1:1, en particulier de 1:2 ou plus.

9. Composant selon l'une des revendications 1 à 5, dans lequel l'élément (1) lui-même est utilisé comme transistor série débloquant ou bloquant la ligne de données (7), **caractérisé en ce que** l'élément (1) est monté directement dans la ligne de données et ouvre ou bloque celle-ci directement, ou **en ce que** l'élément (1) est monté en parallèle à la ligne de données et court-circuite celle-ci ou se comporte de manière transparente.

10. Composant selon la revendication 9, **caractérisé en ce que** l'élément (1), en particulier la cellule TMR (2) ou la cellule OMU, présente(nt) un rapport de résistance entre les deux résistances par rapport à l'état d'au moins 1:5, en particulier d'au moins 1:10 ou supérieur.

11. Composant selon l'une des revendications précédentes, **caractérisé en ce que** le temps de commutation de la résistance de l'élément est inférieur ou égal à 5 ns, en particulier inférieur ou égal à 3 ns.
